# EUROPEAN PATENT APPLICATION

(11) **EP 2 278 446 A2**
(43) Date of publication of application: **26.01.2011**
(21) Application number: 10168770.5
(22) Date of filing: 07.07.2010
(51) Int. Cl.: G06F 3/045

(54) **Touch panel**

(30) Priority: 08.07.2009 CN 200910304137
(71) Applicant: Chimei InnoLux Corporation, Chu-Nan 350, Taipei (TW)
(72) Inventor: Cheng, Jia-Shyong, 350, Chu-Nan (TW); Wu, Jeah-Sheng, 350, Chu-Nan (TW); Chao, Chih-Han, 350, Chu-Nan (TW); Chang, Chih-Chieh, 350, Chu-Nan (TW)
(74) Representative: Gray, John James

(57) **Abstract**

A touch panel including a first substrate (201), a second substrate (203) and a plurality of spacers (408), where the first substrate has a first conductive film (202), and the second substrate has a second conductive film (204). The second substrate is disposed close to the first substrate. The second conductive film is opposite to the first conductive film. The spacers are disposed between the first conductive film and the second conductive film.

## Description

### BACKGROUND OF THE DISCLOSURE

### 1. Field of the Disclosure

The present disclosure generally relates to a touch panel, and more particularly to a panel device with touch window.

### 2. Description of Related Art

Various portable electronic products and electrical equipment are developed to be diverse and multifunctional. These devices can have a touch screen for improving the convenience of a user. The user can input data to these electronic products or equipment via direct touch of his/her fingers or other articles such as a pen with the touch screen such that the reliance on other input devices including keyboard, mouse, and remote controls can be mitigated or eliminated. In this way, it is easy for the user to operate these electronic products or equipment in a more convenient manner.

It is well known that a touch screen is formed by disposing a touch panel in the electrical products or electrical equipment. At present, the so-called touch-panel technology is generally classified as resistance type, capacitance type, infrared type, and ultrasonic type. Recently, a touch panel has been developed to have multiple-position touch function while a conventional one only supports a single position touch function.

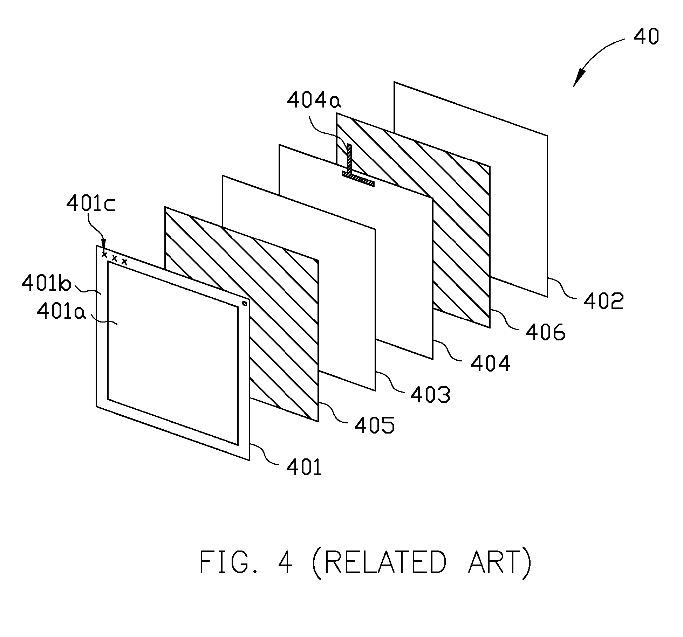

FIG.. 3 and FIG. 4 shows a schematic cross-sectional view of the structure of a conventional touch panel 40 and a schematic view of components of the touch panel 40, respectively. The touch panel 40 includes a top transparent substrate 401, a top indium-tin-oxide (ITO) transparent conductive layer 403, a bottom ITO transparent conductive layer 404 and a bottom transparent substrate 402. Herein, top transparent substrate 401 and bottom transparent substrate 402 are usually polymer substrate, and the top ITO transparent conductive layer 403 and the bottom ITO transparent conductive layer 404 each is usually consisted of a glass substrate and an ITO film.

In addition, ITO transparent conductive layer 404 has a conductive wiring 404a for connecting the conductive layer 404 and the external voltages. The ITO transparent conductive layer 403 is disposed to be opposite to the ITO transparent conductive layer 404. The spacers 408 are disposed between two ITO transparent conductive layers 403 and 404 for keeping a specific distance therebetween, and the peripheral region is fixed by using adhesive 407. In addition, adhesives 405 and 406 with transparent properties are respectively intervened between the transparent substrate 401 and 402 and the corresponding transparent conductive layer 403 and 404. The adhesives 405 and 406 reduce the light transmission loss between the transparent substrates 401 and 402 and the ITO transparent conductive layers 403 and 404, respectively. Therefore, the refractive indexes of the adhesives 405 and 406 are substantially equal to the refractive indexes of the transparent substrates 401 and 402, respectively. An example for the adhesives 405 and 406 is optical clear adhesive and abbreviated as OCA.

On the other hand, the top transparent substrate 401 of the touch panel is usually at the side for touch and is a decoration film including a region 401 a with transparency for the user to perform operations and a mark region 401b for the manufacturers to provide the logos, patterns, or characters 401c thereon by using printing method or other methods.

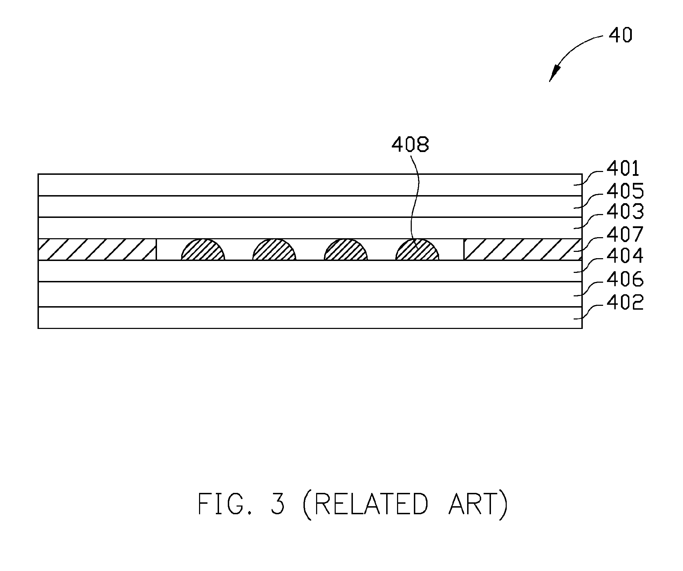

Referring to FIG.3 and FIG. 4, the ITO transparent conductive layers 403 and 404 are each manufactured mainly by forming ITO film on a substrate during a sputtering process. Since the sputtering process needs a high temperature environment, the substrate for carrying the ITO film generally utilizes glass material rather than polymer material which cannot withstand high temperature. In other words, formation of the ITO film by performing sputtering process will be limited with the choice of the substrate. In addition, the participation of the sputtering process technology increases the manufacturing cost of the ITO transparent conductive layer.

In light of the foregoing, in the touch panel development, the subjects of selecting other methods than the sputtering process to form the conductive film on the substrate, forming the conductive film on the substrate in a low temperature environment, and selecting other conductive materials to replace the ITO film become important. Furthermore, it is also noted that reducing the thickness of the touch panel by using pertinent technologies of forming the conductive film on the substrate becomes important when thinning of the electronic products or electrical equipments with a touch panel is required.

In view of FIG.3 and FIG.4, the methods for reducing the thickness of a touch panel include thinning the thickness of the conductive layer, reducing the number of required substrates, and eliminating the use of the OCA. As an example for the above-mentioned touch panel 40, in order to reduce the thickness and the manufacturing cost, the carrier of the ITO conductive layer 403 can be removed, and the ITO conductive film is directly formed on the substrate 401 with the adhesive 405 being avoided. However, as described above, the difficulty of forming the ITO conductive layer on a polymer-made substrate 401 under the high temperature condition of the sputtering process still remains unsolved and a new solution is desired.

### SUMMARY OF THE DISCLOSURE

To resolve the problems of high manufacturing cost and large thickness of a touch panel, a proposal to provide a touch panel with low manufacturing cost and smaller thickness is needed.

According to one embodiment, a touch panel including a first conductive film, a first substrate, a second conductive film, a second substrate, a third substrate, a transparent layer and a plurality of spacers is provided. Herein, one of the dimensions of a component of the first conductive film has an upper limit of 300 nm. The first conductive film is disposed on the first substrate. The second conductive film is disposed on the second substrate. The second substrate is disposed close to the first substrate so that the second conductive film is opposite to the first conductive film. The third substrate is disposed close to the second substrate. The transparent layer is disposed between the second substrate and the third substrate. The spacers are disposed between the first conductive film and the second conductive film. The refractive index of the transparent layer is substantially equal to the refractive index of the second substrate or the refractive index of the third substrate.

In an embodiment, the first substrate is a poly carbon (PC) board, the second substrate is a poly-ethylene-terephthalate (PET) board and the third substrate is a decoration film of PET material. The first conductive film and the second conductive film are carbon nanotube (CNT) conductive films.

In addition, a touch panel including a first conductive film, a first substrate, a second conductive film, a second substrate and a plurality of spacers is provided. Herein, one of the dimensions of a component of the first conductive film has an upper limit of 300 nm. The first conductive film is disposed on the first substrate. The second conductive film is disposed on the second substrate. The second substrate is disposed close to the first substrate so that the second conductive film is opposite to the first conductive film. The spacers are disposed between the first conductive film and the second conductive film. In an embodiment, the substrate is a PC board, and the second substrate is a decoration film of PET material. The first conductive film and the second conductive film are CNT conductive films.

Compared with the conventional touch panel, the present disclosure provides advantages of performing the manufacturing process at a low temperature and reducing the thickness of the panel by decreasing the use of the substrates. For example, when the conductive film is made of CNT film, the conductive film can be easily attached to the high strength PC board via adhesion using adhesive at the low temperature and therefore the use of the OCA can be saved. Therefore, the object of reducing the volume of the product and lowing cost can be achieved.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.

FIG. 1 is a schematic view of the composition of a touch panel according to a first embodiment of the present disclosure.

FIG. 2 is a schematic view of the composition of a touch panel according to a second embodiment of the present disclosure.

FIG. 3 is a schematic cross-sectional view of the structure of a conventional touch panel.

FIG. 4 is a schematic view of the composition of the touch panel in FIG.3.

### DESCRIPTION OF EMBODIMENTS

The composition of a touch panel in the present disclosure includes a first substrate having a first conductive film, a second substrate having a second conductive film and a plurality of spacers. One of the dimensions of a component or a unit of the first conductive film has an upper limit of about 300 nm. For example, the diameter of a component or a unit of the first conductive film is in the range of 10 to 100 nm. One of the dimensions of a component or a unit of the second conductive film is not limited to be not larger than 300 nm. The first conductive film is disposed to be opposite and close to the second conductive film. The spacers are disposed between the first conductive film and the second conductive film. Herein, the above mentioned component or unit of the conductive film can be referred to as a basic particle of the conductive film or a molecule composed of a plurality of the basic particles.

In one embodiment, the first conductive film of the present disclosure is composed of ITO units of nanometer scale. In another embodiment, the fist conductive film of the present disclosure is composed of carbon nanotube (CNT) units. The first conductive film is a conductive film with anisotropic resistance due to the same property of the CNT. It should be understood that when a conductive film has anisotropic resistance, the conductivity or resistance impedance distribution of the conductive film is different in different directions. For example, a CNT film formed through an elongation process is a conductive film having anisotropic resistance.

As will shown below, several embodiments are listed to further explain the composition of the touch panel of the present disclosure. Nevertheless, the touch panel of the present disclosure is not limited therein.

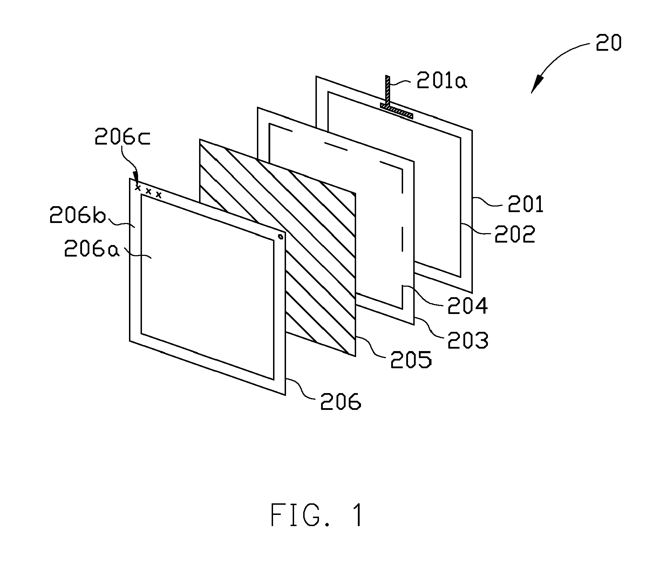

FIG. 1 is a schematic view of the composition of the touch panel 20 according to a first embodiment of the present disclosure. Referring to FIG. 1, the touch panel 20 includes a first substrate 201 having a conductive film 202, a second substrate 203 having a conductive film 204, a transparent layer 205 and a third substrate 206. Herein, the conductive film 202 is composed of a plurality of nanometer scale units, and one of the dimensions of the nanometer scale units has an upper limit of 300 nm. For example, a nanometer scale unit has a diameter in the range of 10∼100 nm.

More specifically, the first substrate 201 has a conductive wiring 201a for connecting the conductive film 202 and external voltages. The second substrate 203 is disposed to be close to the first substrate 201, and the conductive film 202 is disposed to be opposite to the conductive film 204. The third substrate 206 is disposed to be close to the second substrate 203. The transparent layer 205 is disposed between the second substrate 203 and the third substrate 206 for reducing the light transmission loss between the second substrate 203 and the third substrate 206. The transparent layer 205 is, for example, an optical clear adhesive (OCA). In addition, the spacers such as the spacers 408 shown in FIG. 3 are disposed between the conductive film 202 and the conductive film 204. The geometrical shape of the spacers 408 may be isotropic such as circular or anisotropic such as rectangular.

As for the conductive film 202, the nanometer scale units of the conductive film 202 are, for example, nanometer scale ITO units or CNT units. Furthermore, the film composed of the CNT units has anisotropic resistance after an elongation process. The characteristic of anisotropic resistance has been disclosed in foregoing paragraphs and will not be repeated. When the conductive film 202 is composed of the nanometer scale ITO units, the conductive film 202 can be formed on the substrate 201 by non-sputtering process such as coating process at the low temperature under 150 degrees Celsius. When the conductive film 202 is composed of the nanometer scale CNT units, the conductive film 202 can be a CNT conductive film formed through an elongation process, and the conductive film 202 can be easily attached to the substrate 201 by adhesion using an adhesive at the low temperature under 150 degrees Celsius and at 25 degrees Celsius (approximately room temperature).

As for the conductive film 204, it can be a conventional conductive film or a conductive film composed of nanometer units. When the conductive film 204 is a conventional conductive film, the conductive film 204 is formed on the substrate 203 by a sputtering process. For example, the conductive film 204 is an ITO film on a glass substrate. When the conductive film 204 is a conductive film composed of nanometer scale units, these nanometer scale units can be nanometer scale ITO units or CNT units. In addition, the film composed of the CNT units has anisotropic resistance after an elongation processing. The characteristic of anisotropic resistance has been described. When the conductive film 204 is composed of nanometer scale ITO units, the conductive film 204 can be formed on the substrate 203 by using non-sputtering process such as coating process at the low temperature under 150 degrees Celsius. When the conductive film 204 is composed of CNT units, the conductive film 204 can be a CNT conductive film formed through an elongation process, and the conductive film 204 can be easily attached to the substrate 203 by adhesion using an adhesive at the low temperature under 150 degrees Celsius and even under the room temperature of 25 degrees Celsius.

As for the first substrate 201 and the second substrate 203, the material of the first substrate 201 and the second substrate 203 has transparency. The material can be a glass or a polymer with flexibility such as poly-ethylene-terephthalate (PET), poly carbon (PC), poly-methyl-meth-acrylate (PMMA), poly-ethylene (PE) or poly-imide (PI). According to one embodiment, the material of the first substrate 201 is PC, and the material of the second substrate 203 is PET.

As for third substrate 206, it can be a transparent substrate for decoration. The third substrate 206 has a transparent region 206a and a mark region 206b. There are trademarks or patterns or characters 206c formed by printing method or laser drilling method in the mark region 206b. The material of the third substrate 206 can be a polymer with flexibility such as PET, PC, PMMA, PE or PI. According to one embodiment, the third substrate 201 is a PET board.

In the present embodiment, since the transparent layer 205 is disposed for reducing light transmission loss between the second substrate 203 and the third substrate 206, the refractive index of the transparent layer 205 must be close to the refractive index of the second substrate 203 and the refractive index of the third substrate 206. For example, the refractive index of the transparent layer 205 is 0.9 to 1.1 times the refractive index of the second substrate 203 and the refractive index of the third substrate 206.

Compared with the composition of the touch panel in the FIG.4, the conductive film 202 and the substrate 201 in this embodiment are integrated together such that the carrier of the transparent conductive layer 404 and the OCA 406 can be eliminated. Thus, the thickness of the whole touch panel is reduced. Furthermore, the conductive film 202 can be a CNT conductive film such that the conductive film 202 and the substrate 201 can be easily integrated together at the low temperature under 150 degrees Celsius and even under the room temperature of 25 degrees Celsius, and therefore advantages when compared with the composition of conventional touch panel.

As a first example in the present embodiment, the first substrate 201 is a glass board; the conductive film 202 is a CNT film; the conductive wiring 201 a is a FPC board; the second substrate 203 is PET board; the conductive film 204 is a conductive film composed of nanometer scale ITO units; the transparent layer 205 is a OCA and the third substrate 206 is a PET board.

As a second example in the present embodiment, the first substrate 201 is a PC board; the conductive film 202 is a CNT film; the conductive wiring 201a is a FPC board; the second substrate 203 is PET board; the conductive film 204 is a CNT film; the transparent layer 205 is a OCA, and the third substrate 206 is a PET board.

As a third example in the present embodiment, the first substrate 201 is a PC board; the conductive film 202 is a CNT film; the conductive wiring 201 a is a FPC board; the second substrate 203 is a glass board; the conductive film 204 is a conventional ITO film; the transparent layer 205 is a OCA, and the third substrate 206 is a PET board.

The examples of the first embodiment described above are exemplary. The present disclosure is not limited to the first embodiment and the recited examples. All dispositions for a touch panel according to the spirit of the first embodiment of the present disclosure are within the scope of the present disclosure.

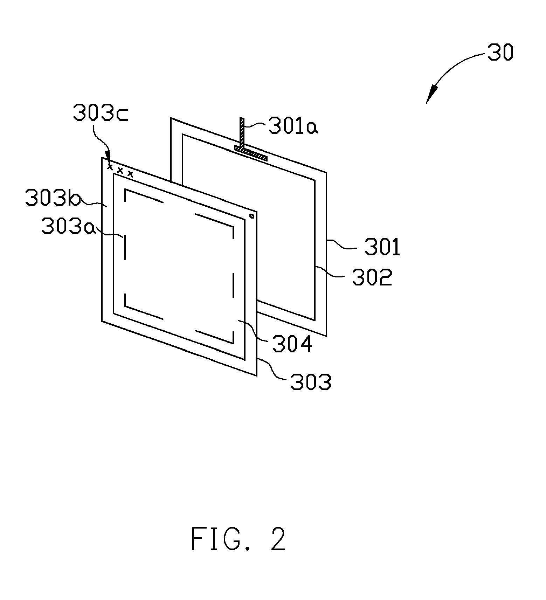

FIG. 2 is a schematic view of the composition of the touch panel according to a second embodiment of the present disclosure. Referring to FIG.2, the touch panel 30 includes a first substrate 301 having a conductive film 302 and a second substrate 303 having a conductive film 304. Herein, the conductive film 302 and 304 are each composed of a plurality of nanometer scale units, and one of the dimensions of these nanometer scale units has an upper limit of 300 nm. For example, a nanometer scale unit has a diameter in the range of 10∼100 nm.

More specifically, the first substrate 301 has a conductive wiring 301a for connecting the conductive film 302 having anisotropic resistance with external voltages. The second substrate 303 is disposed to be close to the first substrate 301, and the conductive film 302 is disposed to be opposite to the conductive film 304. In addition, the spacers such as the spacers 408 shown in FIG. 3 are disposed between the conductive film 302 and the conductive film 304. The geometrical shape of the spacers 408 may be isotropic such as circular or anisotropic such as rectangular.

As for the conductive film 302, the nanometer scale units of the conductive film 202 are, for example, nanometer scale ITO units or CNT units. Furthermore, the film composed of the CNT units has anisotropic resistance after an elongation processing. The characteristic of anisotropic resistance has been described. When the conductive film 302 is composed of the nanometer scale ITO units, the conductive film 302 can be formed on the substrate 301 by using non-sputtering process such as coating process at the low temperature under 150 degrees Celsius When the conductive film 302 is composed of the nanometer scale CNT units, the conductive film 302 can be a CNT conductive film formed through an elongation process, and the conductive film 202 can be easily attached to the substrate 201 by adhesion using an adhesive at the low temperature under 150 degrees Celsius and even under the room temperature of 25 degrees.

As for conductive film 304, it is a conductive film composed of nanometer scale units including nanometer scale ITO units and CNT units. Furthermore, the film composed of the CNT units has anisotropic resistance after an elongation processing. The characteristic of anisotropic resistance has been described. When the conductive film 304 is composed of the nanometer scale ITO units, the conductive film 304 can be formed on the substrate 303 by using non-sputtering process such as coating process at the low temperature under 150 degrees Celsius. When the conductive film 304 is composed of the CNT units, the conductive film 304 can be a CNT conductive film formed through an elongation process, and the conductive film 304 can be easily attached to the substrate 203 by adhesion using an adhesive at the low temperature under 150 degrees Celsius and even under the room temperature of 25 degrees.

As for the first substrate 301, the material of the first substrate 301 has transparency. The material can be a glass or a polymer with flexibility such as poly-ethylene-terephthalate (PET), poly carbon (PC), poly-methyl-meth-acrylate (PMMA), poly-ethylene (PE) or poly-imide (PI). As for second substrate 303, it can be a transparent substrate for decoration. The second substrate 303 has a transparent region 303a and a mark region 303b. There are trademarks or patterns or characters 306c formed by printing method or laser drilling method in the mark region 303b. The material of the second substrate 303 can be a polymer with flexibility such as PET, PC, PMMA, PE or PI. According to one embodiment, the material of the first substrate 301 is PC, and the material of the second substrate 303 is PET.

Compared with the composition of the touch panel in the FIG.4, the conductive film 302 and the substrate 301 in this embodiment are integrated together and the conductive film 304 and the substrate 303 are integrated together, such that,the carrier for the transparent conductive layers 403 and 404 and the two OCAs 405 and 406 can be eliminated. Thus, the thickness of the whole touch panel is reduced. Furthermore, the conductive films 302 and 304 can be CNT conductive films such that the conductive films 302 and 304 can be easily integrated together with the substrates 301 and 303, respectively, at the low temperature under 150 degrees Celsius and even under the room temperature of 25 degrees Celsius, and therefore advantages when compared with the composition of the conventional touch panel.

As a first example in the present embodiment, the first substrate 301 is a PC board; the conductive film 302 and 304 are CNT films; the conductive wiring 301a is a FPC board and the second substrate 303 is a PET board for decoration.

As a second example in the present embodiment, the first substrate 301 is a glass board; the conductive films 302 and 304 are CNT films; the conductive wiring 301a is a FPC board and the second substrate 303 is a PET board for decoration.

The examples of the second embodiment described above are exemplary. The present disclosure is not limited to the second embodiment and the recited examples. All dispositions for a touch panel according to the spirit of the second embodiment of the present disclosure are within the scope of the present disclosure.

The foregoing various description and embodiments are exemplary and not intended to limit the scope of the present disclosure. It will be apparent to those skilled in the art that various modifications and alternatives can be made to the present disclosure without departing from the scope or spirit of the disclosure. Therefore, the protection for the present disclosure is on the basis of the appended claims.

## Claims

1. A touch panel, comprising:
a first substrate having a first conductive film;
a second substrate having a second conductive film being opposite to the first conductive film; and
a plurality of spacers disposed between the first conductive film and the second conductive film;
wherein one of the dimensions of a component of the first conductive film has an upper limit of about 300 nm.

2. The touch panel as claimed in claim 1, wherein number of the substrates included in the touch panel has an upper limit of 3.

3. The touch panel as claimed in claim 1 or 2, wherein the first conductive film is formed on the first substrate through a coating or adhesion process.

4. The touch panel as claimed in claim 3, wherein the first conductive film is an indium-tin-oxide conductive film.

5. The touch panel as claimed in claim 1, 2, 3 or 4, wherein the first conductive film includes a carbon nanotube.

6. The touch panel as claimed in claim 5, wherein the first conductive film is formed through an elongation process.

7. The touch panel as claimed in claim 5, wherein the first conductive film has anisotropic resistance.

8. The touch panel as claimed in any preceding claim, wherein the first substrate is made of a material selected from polymer and glass.

9. The touch panel as claimed in any preceding claim, wherein the first substrate has flexibility.

10. The touch panel as claimed in any preceding claim, wherein the first substrate is made of a material selected from PC, PET, PMMA, PE and PI.

11. The touch panel as claimed in any preceding claim, wherein the first substrate has a mark selected from patterns and characters.

12. The touch panel as claimed in any preceding claim, wherein one of the dimensions of a component of the first conductive film has a range of 10∼100 nm.

13. The touch panel as claimed in any preceding claim, further comprising:
a third substrate; and
a transparent layer disposed between the second substrate and the third substrate.

14. The touch panel as claimed in claim 13, wherein the refractive index of the transparent layer is 0.9 to 1.1 times one of the refractive index of the second substrate and the refractive index of the third substrate.

15. The touch panel as claimed in claim 13 or 14, wherein one of the first conductive film and the second conductive film includes a carbon nanotube.

16. The touch panel as claimed in claim 15, wherein one of the first conductive film and the second conductive film is formed through an elongation process.

17. The touch panel as claimed in claim 15 or 16, wherein one of the first conductive film and the second conductive film has anisotropic resistance.

18. The touch panel as claimed in claim 13, 14, 15 or 16, wherein the second substrate is made of a material selected from PC, PET, PMMA, PE and PI.

19. The touch panel as claimed in any of claims 13 to 18, wherein the third substrate is made of a material selected from PC, PET, PMMA, PE and PI.

20. The touch panel as claimed in any of claims 13 to 19, wherein the third substrate has a mark selected form patterns and characters.
